# EUROPEAN PATENT APPLICATION

(11) **EP 4 797 001 A1**
(43) Date of publication of application: **26.08.2026**
(21) Application number: 25159505.4
(22) Date of filing: 21.02.2025
(51) Int. Cl.: G03F 7/20

(54) **SUBSTRATE STAGE SYSTEM AND METHOD, AND EXPOSURE APPARATUS INCLUDING THE SYSTEM**

(71) Applicant: ASML Netherlands B.V., 5500 AH Veldhoven (NL)
(72) Inventor: HUANG, Yang-Shan, 5500 AH Veldhoven (NL); JANSEN, Erik, 5500 AH Veldhoven (NL); KRAMER, Gijs, 5500 AH Veldhoven (NL); NOUWEN, Stijn, 5500 AH Veldhoven (NL); SMEETS, Benjamin, Cunnegonda, Henricus, 5500 AH Veldhoven (NL)
(74) Representative: ASML Netherlands B.V.

(57) **Abstract**

The present disclosure provides a stage system for supporting a substrate having a thickness exceeding a nominal range, comprising: a base surface; a first module movably arranged on the base surface; a second module for supporting the substrate and movably arranged on the first module; a plane of interest extending planar to a top surface of the second module at a position on or above said top surface; height adjustment means for adjusting vertical positions of the first module and the second module; and a controller configured to control relative distances between the base surface, the first module, the second module, and the plane of interest, while keeping a summation of the relative distances constant.

## Description

### FIELD

The present invention relates to a substrate stage system and method. The substrate herein may be a wafer or other type of substrate suitable for lithographic processing. The disclosure also relates to an exposure apparatus including the substrate stage system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

In semiconductor device manufacturing processes, apparatuses can be used to process and/or assess objects such as a substrate or a patterning device. An example of such an apparatus is an exposure apparatus used to generate interactions between certain radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged -particle radiation with an object such as a substrate or a patterning device. An inspection apparatus and a metrology apparatus are examples of such assessment apparatuses and may be used to detect particles or measure a critical dimension, for example.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

**In** an everlasting effort to speed up production, substrate handling is streamlined into utmost detail. Typically, a wafer stage of a lithography apparatus has at least two substrate tables. A first substrate table may allow to perform preparatory measurements at the measure side, while a second substrate table enables exposure of another substrate in parallel at the exposure side. Typically, a substrate table comprises at least two parts, which can move across a flat surface. The two parts are a so-called long-stroke module, which allows relatively coarse and longer distance movements across said surface. A second module, which may be referred to as a short-stroke module, can be arranged on top of the long stroke module. The short stroke module herein delivers fine tuning of the position of a substrate placed on top of the module.

During operation of a lithographic apparatus, the short stroke modules are controlled such that the wafer on top of it is in focus with respect to patterning radiation. Problems may arise however when cycling relatively thick substrates. For instance, the thickness of substrates tends to increase with the number of layers arranged on the respective substrate. As the semiconductor industry aims to keep increasing the capacity of semiconductor circuits, said number of layers tends to increase. For instance, at present, it is not uncommon for printed circuits to comprise more than 400 layers, sometimes up to 600 layers. Herein, while the first few layers may be printed on a substrate (such as a silicon wafer) which is substantially flat and has a predetermined thickness, problems may arise when printing further layers. Substrates tend to bend, due to the metallic layers having varying thermal expansion. Yet, for the present disclosure, with increasing numbers of printed layers, the thickness of substrates may start to exceed a certain maximum threshold for which the respective lithographic apparatus has been designed. Herein, some dimensions, such as the distance between the long stroke module and the flat surface, are relatively critical and as a result cannot be changed. Also, long stroke and short stroke modules are relatively expensive, while their design lifetime is often many years, so re-designing these modules would negatively impact the economic viability of the lithographic apparatus.

US-20180335705-A1 discloses a positioning device with a first positioning module member holding an object table, a second positioning module member supporting the first module member, and a control unit configured to control a vertical position of the second module member to maintain the top surface of the second module member parallel to the bottom surface of the first positioning module member. The positioning device however is unsuitable for handling substrates exceeding a certain threshold thickness.

CN-116974146-A discloses a stage apparatus with coarse and fine moving stages. The document seems to mention how the thickness variation of the substrate (for instance, when using a calibration mark) might affect a distance (that is maintained to a positive value) between movable and fixed elements of the fine moving stage. The positioning device however is unsuitable for handling substrates exceeding a certain threshold thickness and lacks control options to do so.

WO-2024223155-A1 discloses a lithography apparatus and a method to control the separation distance 302 between a fluid handling structure 301 and substrate W or substrate support WT depending on the substrate thickness. The methods works, for instance, by moving the substrate W or substrate support WT vertically.

Despite the improvements provided by the prior art devices as exemplified above, in practice, processing substrates having a thickness exceeding a threshold remains challenging. As substrate tables are relatively expensive equipment parts, re-designing substrate tables in legacy machines is typically not economically viable.

The present disclosure aims to provide a system and method to extend the maximum thickness of substrates which can be processed by legacy machines.

### SUMMARY

The disclosure provides a stage system for supporting a substrate having a thickness exceeding a nominal range, comprising:
a base surface;
a first module movably arranged on the base surface;
a second module for supporting the substrate and movably arranged on the first module;
a plane of interest extending on or above a top surface of the second module;
height adjustment means for adjusting vertical positions of the first module and the second module; and a controller configured to control relative distances between the base surface, the first module, the second module, and the plane of interest, while keeping a summation of the relative distances constant.

In an embodiment, the height adjustment means are adapted to also adjust a vertical position of the base surface.

In an embodiment, the height adjustment means comprise at least one motor system for adjusting the vertical position of the base surface.

In an embodiment, the at least one motor system is arranged between a base frame and a balance mass which includes the base surface.

In an embodiment, the at least one motor system comprises a hydraulic or pneumatic actuator for adjusting a protrusion between a first position and a second, extended position.

In an embodiment, the at least one motor system comprises a mechanic drive system for adjusting a protrusion between a first position and a second, extended position.

In an embodiment, the height adjustment means are adapted to adjust the vertical position of the plane of interest.

In an embodiment, the height adjustment means include adjustable air mounts coupled to a metrology frame which defines the plane of interest.

According to another aspect, the disclosure provides an exposure apparatus, the apparatus comprising:
stage system for supporting a substrate having a thickness within a nominal range, the stage system comprising:
a base surface;
a first module movably arranged on the base surface;
a second module for supporting the substrate and movably arranged on the first module;
a plane of interest extending on or above a top surface of the second module;
height adjustment means for adjusting vertical positions of the first module and the second module; and a controller configured to control relative distances between the base surface, the first module, the second module, and the plane of interest, while keeping a summation of the relative distances constant.

In an embodiment, the stage system comprises:
at least one substrate handler for moving substrates onto the second module;
an exposure system for exposing a substrate positioned on the second module;
wherein the controller is adapted to reduce a vertical position of a respective substrate with respect to the exposure system if a thickness of the substrate exceeds the nominal range.

In an embodiment, the exposure apparatus comprises a metrology frame which is connected to the exposure system, and second height adjustment means for adjusting a vertical position of the metrology frame with respect to the second module.

In an embodiment, the second height adjustment means comprise adjustable air mounts supporting the metrology frame.

According to yet another aspect, the disclosure provides a method for supporting a substrate having a thickness exceeding a nominal range, comprising:
providing a stage system, the stage system comprising
a base surface;
a first module movably arranged on the base surface;
a second module for supporting the substrate and movably arranged on the first module; and
a plane of interest extending on or above a top surface of the second module;
arranging a substrate on the second module; and
if a thickness of the substrate exceeds the nominal range, adjusting relative distances between the base surface, the first module, the second module, and the plane of interest, while keeping a summation of the relative distances constant.

In an embodiment, the step of adjusting relative distances comprises controlling a first vertical distance of the second module with respect to the first module, and controlling a second vertical distance of the first module with respect to the base surface.

In an embodiment, the method comprises the further step of adjusting a vertical position of the base surface; or adjusting a vertical position of the plane of interest.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a top view of an exemplary substrate stage of a lithographic apparatus;
- Figure 3 depicts a side view of an exemplary substrate stage of a lithographic apparatus;
- Figure 4A depicts a side view of a substrate table comprising a long stroke module and a short stroke module;
- Figure 4B depicts a side view of an embodiment of a substrate table comprising a long stroke module and a short stroke module;
- Figure 5A depicts a side view of an embodiment of a substrate stage in a first position;
- Figure 5B depicts a side view of the substrate stage of Fig. 5A in a second position;
- Figure 6 depicts a cross section of an embodiment of a system to adjust the position of a substrate table with respect to an exposure system;
- Figure 7 depicts a cross section of another embodiment of a system to adjust the position of a substrate table with respect to an exposure system;
- Figure 8A depicts a perspective view of an embodiment of a system to adjust the position of a substrate table with respect to an exposure system;
- Figure 8B depicts a cross section of the system of Figure 8A;
- Figure 9A depicts a perspective view of an embodiment of a system to adjust the position of a substrate table with respect to an exposure system;
- Figure 9B depicts a cross section of the system of Figure 9A; and
- Figure 10 depicts another embodiment of an exposure apparatus provided with an embodiment of a stage system.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "overlay error" as used herein refers to horizontal placement error between respective layers of a lithographic process. Said horizontal error may typically impact the quality of a chip. One key task of a lithography apparatus is the ability to image dense lines and spaces from the mask to the wafer. Here, the critical dimension (the width of a line), the pitch (the distance between lines) and the straightness of each of the lines are important, as well as overlay error.

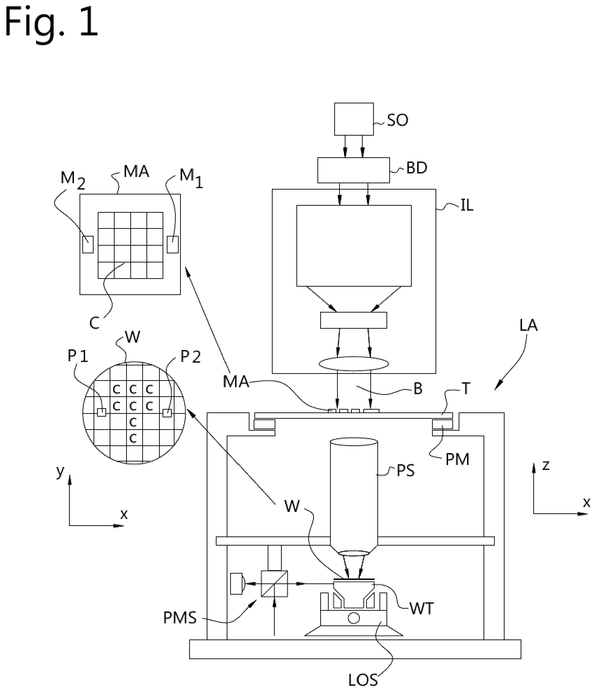

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner LOS configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

As depicted in Figure 1, the lithographic apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus LA may be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner LOS and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

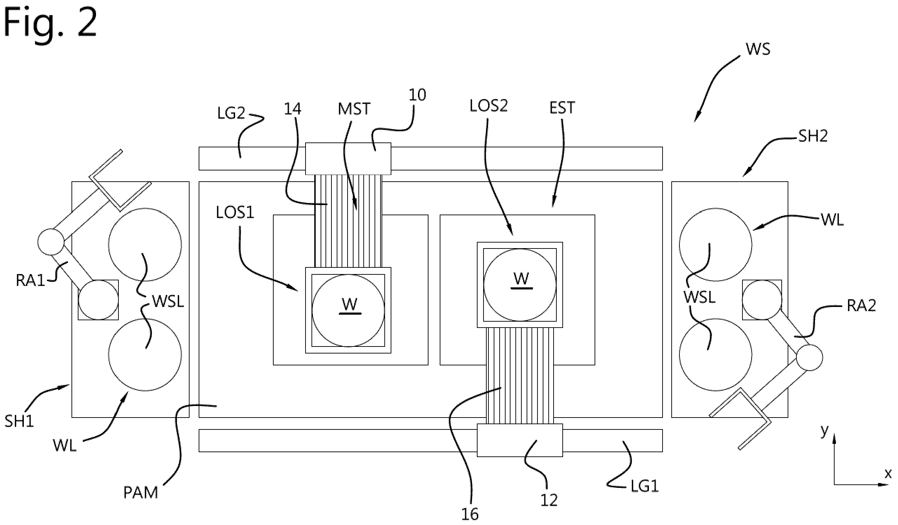

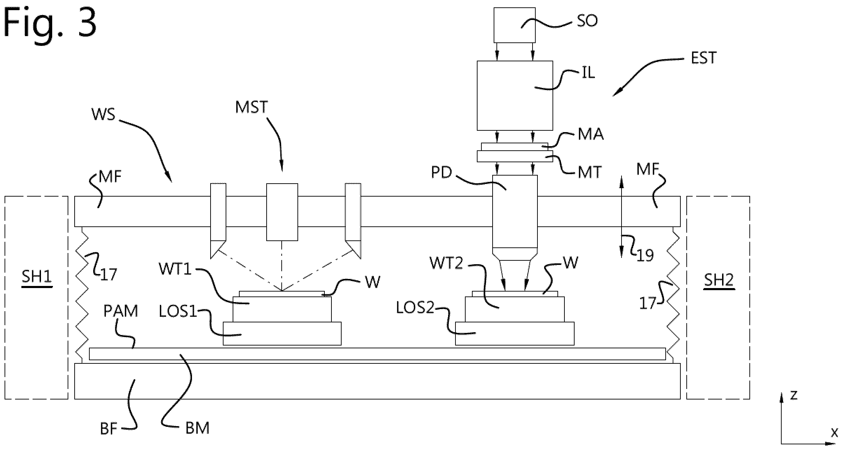

Figures 2 and 3 show an exemplary overview of a substrate stage WS.A base frame BF supports the substrate stage. The base frame basically is a frame having a reference position. The reference position is substantially fixed with respect to the environment.

Relatively large horizontal forces due to repeated acceleration and deceleration of the respective substrate tables WS can at least partially be absorbed using a balance mass principle. Herein, a balance mass unit BM is arranged between the substrate table WS and the base frame BF. The balance mass BM may typically have a substantially flat and planar top surface PAM.

The balance mass BM may typically be connected to the base frame via one or more bearings, which in turn may be provided in or on a bearing frame. The bearing frame may be connected to the base frame BF via support legs. The bearings may be air bearings, and the bearing frame may be an air bearing frame. An actuator or comparable controller may be arranged between a horizontal edge of the balance mass BM and the base frame BF. The actuator or comparable controller element may dampen or obviate horizontal drift of the balance mass with respect to the base frame. The latter is not shown in detail in the figures.

In the field of lithography, the positioning modules LOS1, LOS2 may also be referred to as a "long stroke module". The corresponding substrate tables WT1, WT2 may also be referred to as a "short stroke module". The substrate stage may comprise one, two or more substrate tables WT1, WT2. The substrate tables are moveable with respect to the planar surface PAM.

One or more guide rails LG1, LG2 may be provided at or near, for instance adjacent to, the planar surface. Each positioning module or long stroke module LOS1, LOS2 of a respective substate table WT1, WT2 may be connected to one of the guide rails via a moveable coupling 10, 12. The coupling 10, 12 may allow, for instance, linear movement along a respective guide rail. The respective long stroke module LOS1, LOS2 can be connected to the respective coupling 10, 12 via a linearly extendable connection 14, 16. Said linearly extendable connection may comprise, for instance, a flexible cable slab. The cable slab may comprise one or more cables, for instance to provide power, cooling, and data to and from the respective positioning module. The positioning modules or long stroke modules LOS 1, LOS2 are adapted to allow planar movement of the respective modules with respect to the planar surface PAM. The substrate stage WT may comprise drive means for moving the substrate modules with respect to the planar surface. The drive means may be based on, for instance, a mechanical direct drive, or electromagnetic drive means. An electromagnetic drive system may comprise, for instance, electromagnets arranged in the balance mass BM and/or the long stroke modules LOS1, LOS2.

For instance, a planar motor concept may be implemented to realize horizonal accelerations of the respective long stroke modules of the substrate tables WT. A planar motor may include a magnet array, forming a so called Magnet Plate. The magnet array can be arranged, for instance, on top of the balance mass BM or may be integral to the balance mass BM. The magnet array herein may contribute to the total mass of the balance mass BM. Alternatively, a magnet array formed by (superconductive) magnetic coils may be included in the balance mass. Corresponding magnetic coils of the planar motor concept may be comprised in or on the bottom surface of a respective long stroke module LOS1, LOS2.

The respective substrate tables WT1, WT2 may typically be able to move with respect to the corresponding positioning modules LOS1, LOS2. Herein, the long stroke modules LOS1, LOS2 may typically enable relatively fast movement over relatively longer distances. The substrate tables WT1, WT2 may enable very accurate movements yet over a (much) shorter distance.

One or more substrate handlers SH1, SH2 may be arranged adjacent to the substrate stage WS. The respective substrate handler typically comprises one or more storage positions WSL for holding a stack of substrates. The stack of substrates may also be referred to as a substrate lot WL. A substrate lot herein typically comprises a number of substrates each intended for a specific step in a lithographic process. Each substrate handler may be provided with one or more robot arms RA1, RA2 for transferring substrates W from one of the storage locations WSL to one of the substrate tables, or vice versa.

The substrate stage may be provided with an exposure station EST. The exposure station may refer to a location or area where a substrate W positioned on one of the one or more substrate tables can be exposed to radiation for patterning resist on said substrate. See also Figure 1 and the related description above. The substrate stage may be provided with another location or area intended for executing certain measurements. Said location or area may be referred to as measurement station MST. The measurements herein may include, but are not limited to, pre-expose measurements - such as surface, height, and topography mapping, and accurate positioning- and post-expose measurements such as control of exposed patterns. The measurement station MST, see Fig. 3, may include one or more sensors and related control equipment intended for the measurements as referenced. However, said sensors may also be included in or on the respective substrate tables or at any other viable position.

The exposure station EST and/or the measurement station MST may be arranged in a metrology frame MF. The metrology frame MF may be connected to the environment via an isolating connection 17. The isolating connection 17 may comprise, for instance, one or more air mounts. The isolating connection may be vertically adjustable, allowing to adjust a vertical position of the metrology frame MF, as indicated by arrow 19.

Please note that Figures 2 and 3 serve as a generic reference. Many other setups for a substrate stage are conceivable. Basically, the figures exemplify how a single substrate stage may comprise multiple substrate tables which can move individually with respect to each other and be involved in different steps of the lithographic process in parallel.

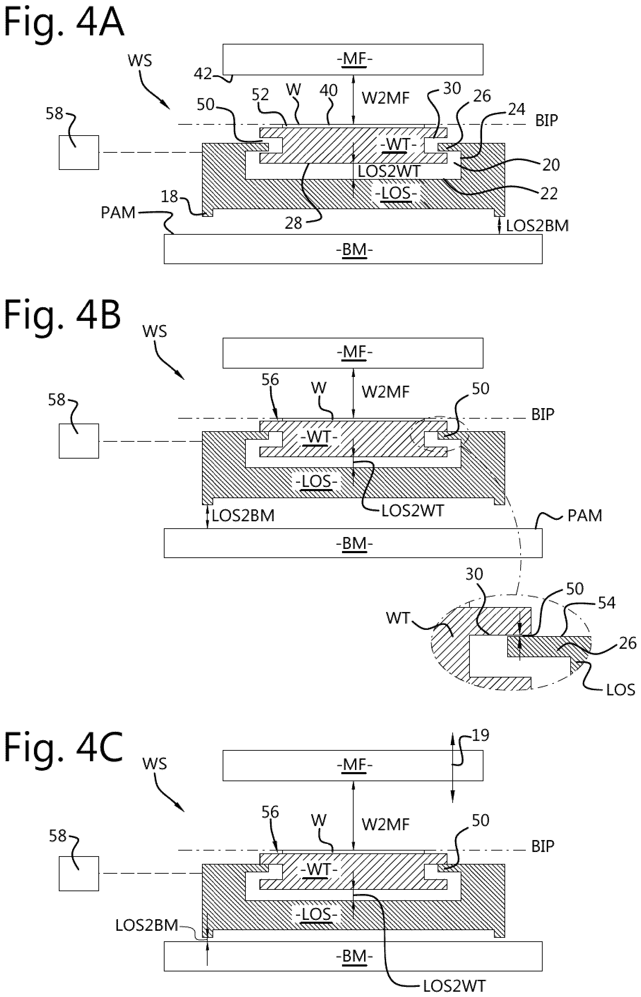

Generally referring to Figure 4A, a substrate stage WS may have several related mutual distances between respective parts, which in combination ensure the proper functioning of the respective substrate stage.

For instance, a first distance LOS2BM may be the distance between a lower end 18 of the long stroke module LOS and an upper end of the balance mass BM. Herein, said upper end of the balance mass typically equate with the planar surface PAM.

A second distance LOS2WT may be the distance between a lower end 28 of the substrate table or short stroke module WT and an upper end 22 of the long stroke module LOS. Herein, said upper end of the long stroke module may, as exemplified in Figure 4A, relate to a cavity or carve out section 20 designed to receive the respective short stroke module WT. Said cavity 20 may have a lowered bottom 22 and side walls 24. An upper end of the cavity 20 may be provided with a flange 26 or comparable protrusion. A side of the short stroke module WT may have a shape corresponding to said protrusion or flange 26. For instance, the sides 30 of the short stroke module may have a C-shape allowing to enclose the flange 26.

A third distance W2MF may be the distance between a top end 40 of the substrate W positioned on the substrate table WT, and a lower end 42 of an equipment frame MF. The frame MF may be a metrology frame MF. A metrology frame herein may relate to the measurement station MST. The metrology frame may be a frame or assembly comprising equipment, such as sensors. Alternatively, the frame may relate to the projection system PS and the expose station EST.

The third distance W2MF typically relates to a plane of focus BIP. Said plane of focus is typically related to the optics of the expose station EST. The plane of focus can be defined as a plane wherein a pattern as projected onto the substrate by the projection system PS is in focus. The plane of interest BIP may also refer to the plane wherein one or more features (such as alignment marks) on the topside, bottom side or inside of the substrate W are in focus. Thus, the plane of interest BIP may be aligned with the top surface of the substrate W. Alternatively, said plane BIP may be located at a vertical position below the top side of the substrate W.

In a lithographic apparatus LA, in practice, the projection system PS is kept stationary, whereas the substrate W and the respective substate table WT and corresponding long stroke module LOS can move vertically within a certain range. In operation, the lithographic apparatus controls the vertical position of the assembly of substrate table WT and long stroke module LOS to keep the upper surface of the substate W in focus.

The thickness of the substrate herein is defined as the distance between the upper end 40 of the substrate W and a bottom surface 52 of the same substrate W. Please note that substrate thickness can differ for different substrates, and may depend on the number of layers already deposited on the substrate. The upper end 40 of the substrate herein may extend above a top surface of the substrate, due to one or more metallic patterns deposited on said top surface during various steps of the lithographic process. The distance between the plane of interest BIP and the top surface of the short stroke module WT can also be the effective thickness of the substrate W. Herein, all distances are summed up and rebalanced within the same sum.

A fourth distance 50 may relate to the distance between an upper end 54 of the flange 26 and a lower end 30 of the C-shaped section 56 of the long stroke module LOS.

The substrate stage herein is provided with height adjustment means for adjusting vertical positions of the first module, or long stroke module LOS and the second module, or short stroke module WT. Herein, the substrate stage typically comprises a controller 58. The controller may be configured to control relative distances between the base surface PAM, the first module LOS, the second module WT, and the plane of interest or plane of focus BIP, while keeping a summation of the relative distances constant.

In a practical embodiment, a wafer stage WS may use the principle of a magnetically levitated positioning module. Herein, the long stroke module hovers above the balance mass due to magnetism. The short stroke module WT hovers above the long stroke module LOS due to magnetic force of electro magnets in the sides, typically in the C-shaped section 56 and the flange 26.

In Figure 4B, the range of movement of the flange 26 is shown to the structurally limited by the C-shaped section, thus limiting the range of motion between the short stroke module WT and the long stroke module LOS. In a practical implementation, said range of motion may be limited due to a limited range of respective actuators, electromagnetic drive elements, or other modules or mechanics. Nevertheless, the governing principle remains the same, i.e. the short stroke module can move with respect to the long stroke module in vertical direction over a certain range of motion, and said range of motion has an upper and lower limit or threshold.

During operation, for instance exposure steps, wafer alignment, wafer levelling and other actions in between exposure and positioning, the short stroke module WT is typically controlled such that the top surface of the substrate W is in the focal point or focal plane BIP of a respectively projection system PS, alignment sensor or level sensor.

Conventionally, the second distance LOS2WT is typically maintained in the middle of the available range. See Fig. 4A. Said range may be set by the C-shaped section 56 of the substrate table WT. As a result, the first distance LOS2BM is a result of the setpoint for the second distance LOS2WT, in combination with dynamics and deformations of respective equipment and parts during operation.

As referenced in the introduction, it is often challenging to maintain healthy ranges while cycling thicker substrates. However, also for relatively thin substrates, the nominal relative distance between machine parts may be suboptimal or exceed tolerances, as the range is typically symmetric. Said range may be important in respect of, for instance, linearity, optimal force, heating, or even collision (of the short stroke module and the long stroke module). Herein, typically, the substrate stage WS may typically be designed for substrates having a thickness within a range, which may be referred to as the nominal thickness range. Said nominal range typically has an upper threshold and a lower threshold. Relatively thick substrates exceed said upper threshold, whereas relatively thin substrates have a thickness below said lower threshold.

Aggressive dynamics, aberrations in the flatness of the top surface PAM of the balance mass BM, deformations of the long stroke module during acceleration, and substrate thickness, all relatively heavily influence the available tolerance of the first distance LOS2BM. Herein, typically, for proper operation of the substrate stage WS, the first distance LOS2BM may be the most critical. In other words, the first distance LOS2BM typically has a lower threshold which cannot be crossed. If the first distance LOS2BM may drop below said lower threshold, proper operation cannot be guaranteed. For instance, due to vibrations, tilt and material deformation due to acceleration, etc., below the lower threshold it cannot be guaranteed that the long stroke module LOS will not engage the balance mass. Engagement of both parts at high speed may result in significant damage, system malfunction and due to system downtime significant costs due to a reduction of throughput .

So, in a first method of operation, see Figure 4A, if the thickness of a substrate W may exceed a certain upper threshold, the long stroke module LOS can be lowered with respect to the balance mass BM, reducing the first distance LOS2BM to accommodate the relatively thick substrate W.

However, in a practical embodiment, see Figure 4B, instead of reducing the first distance, the system and method of the present disclosure propose to sacrifice at least part of the second distance LOS2WT at the benefit of the first distance LOS2BM. Herein, if the thickness of a substrate may exceed a certain upper threshold, the short stroke module WT can be lowered within the long stroke module LOS. Herein, the second distance LOS2WT and the fourth distance 50 are reduced. Herein, one of the fourth distance 50 and the second distance LOS2WT may set a maximum threshold for the range of vertical movement of the short stroke module WT with respect to the long stroke module.

Thus, when the thickness of a substrate exceeds a set threshold, in a first step, the short stroke module WT may be lowered with respect to the long stroke module. The detail of Figure 4B indicates that at least a lower threshold of the fourth distance 50 remains, to avoid the short stroke module from mechanically engaging the long stroke module.

Only if the thickness of the respective wafer W exceeds an upper threshold for substrate thickness beyond the available vertical range of motion of the short stroke module (see the detail of Fig. 4B), in a next step the substrate stage WS may reduce the first distance LOS2BM. As referenced above, said first distance LOS2BM can only be reduced up until a lower threshold. Yet, by the reduction of the fourth and second distance, of the short stroke module WT with respect to the long stroke module, the method and system of the disclosure create more vertical range of motion and thereby extend the range of substrate thickness which can still be processed.

As the top surface of the substrate will be in focus during critical actions in the lithographic apparatus LA, every additional micrometre which is gained from benefitting of the available tolerances, for instance of the second distance LOS2WT and fourth distance 50, directly translates into additional margin to process thicker substrates.

Reducing the fourth distance 50 may slightly impact motor linearity of the motor system driving the short stroke module with respect to the long stroke module LOS. Said motor is, typically, an electromagnetic drive, as outlined above. Slightly herein may mean that reduction of the second and fourth distance in a range of about 0 to 100 µm or more, or alternatively in the range of about 0 to 50 µm, can be done without noticeably impacting performance of the substrate stage. The latter basically means that the system and method of the disclosure enable to increase the thickness range of substrates on the order of 50 to 100 µm without impacting the performance or without impacting the first distance LOS2BM.

In addition to the above, it may be desired to further increase the vertical range of motion available to be able to accommodate even thicker substrates.

As described above, typically, both the long stroke module LOS and the short stroke module WT may use magnetic levitation to lift and move with respect to the balance mass and the long stroke module respectively.

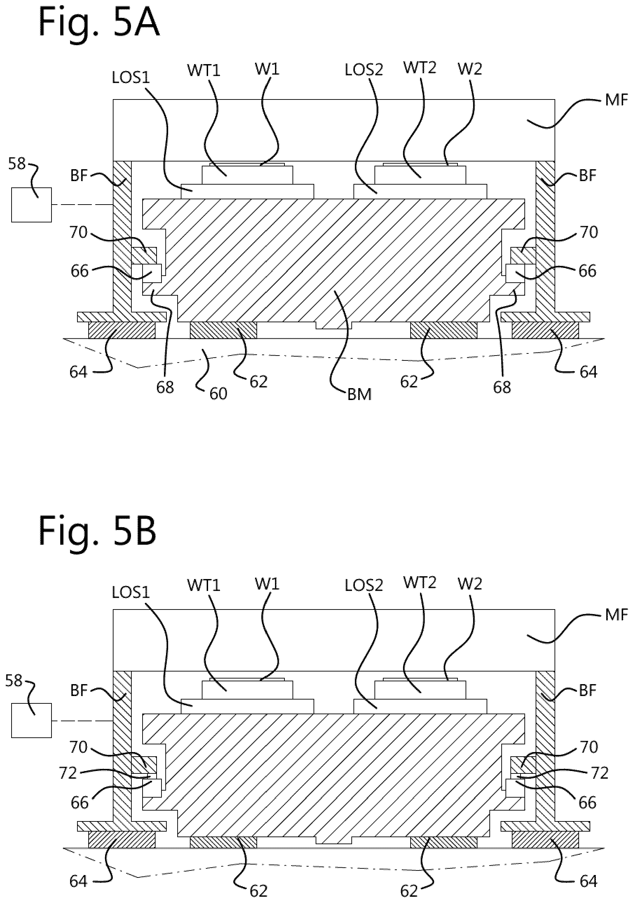

Generally referring to Figure 5A, the balance mass BM may be connected to a base frame BF, which is also ultimately connected to the metrology frame MF with or without additional damping and compliance. The assembly of the system, including the substrate table(s) and the balance mass BM, are typically arranged on a floor 60 of a fabrication facility. Damping means are typically provided between the balance mass BM and the floor 60, to avoid or at least limit transfer of vibrations. For instance, one or more bellows 62 may be arranged between the floor 60 and the respective balance mass. The bellows 62 herein may typically include gas filled flexible containers. The gas pressure in the respective bellow can be controlled and adjusted in accordance with requirements. In a practical embodiment, the gas pressure in the respective bellows 62 may be in the range of 2 to 6 bars, for instance about 3 to 5 bars. In a practical embodiment, the balance mass is supported by a frame (not shown). This balance mass frame is supported by the bellows and forms the interface between the balance mass and the bellows.

The base frame BF may be arranged adjacent to the balance mass. The base frame BF can be connected to the floor via, for instance, respective feet or fixtures 64. The respective feet 64 are typically relatively stiff. In comparison to the feet 64, the bellows 62 are relatively flexible.

The balance mass BM can be provided with one or more motors 66. Said motors 66 may be arranged, for instance, in between first protrusions 68 of the balance mass BM, and second protrusions 70 of the base frame.

In a first position, shown in Figure 5A, the motors 66 may be in a retracted position or first position. Herein, a plunger or actuator section of the motors is retracted. In a second position, shown in Figure 5B, the actuator section or plunger 72 of the respective motors 66 may be in an extended position, or second position. Herein, the actuator sections 72 push the balance mass downward with respect to the base frame BF. Due to the flexibility difference between the bellows 62 and the feet 64, basically, the actuators 72 push the balance mass downward into the bellows, while the base frame and the corresponding feet 64 remain stationary.

The motors 66 enable to lower or reduce the vertical position, or Z-position, of the substrate stage WS with respect to the metrology frame MF. Thus, by moving the motors to the second or extended position, the balance mass BM is pushed downward, increasing the distance between the substrate tables WT1, WT2 and the metrology frame MF. The latter allows to process thicker substrates, i.e. increases the range of thickness which can be processed.

In a practical embodiment, the system shown in Figures 5A and 5B can handle substrates, such as wafers, having a thickness ranging from about 775 µm (virtually an industry standard) up to substrate thickness on the order of 830 µm or more, 900 µm or more, or even 1500 µm or more. The system can handle relatively thin substrates as well, down to a thickness of, for instance, about 400 µm, 300 µm or 200 µm.

Motor system 66 may comprise a hydraulically or pneumatically driven motor. Herein, forces required to displace the balance mass in vertical direction counteracting the pressure exerted by the bellows 62 (for instance on the order of 4 bar) is relatively high (for instance, about 400 kN or more). Herein, the range of motion of an actuator element of the motor system may be on the order of +/- 0.5 mm. It is relatively difficult to provide a motor which can handle forces at such levels reliably. On the other hand, as referenced before, re-designing substrate stages, an alternative, is typically not economically viable. Exemplary embodiments of potential motor systems 66 suitable to handle the required forces in a stable and reliable manner are described below.

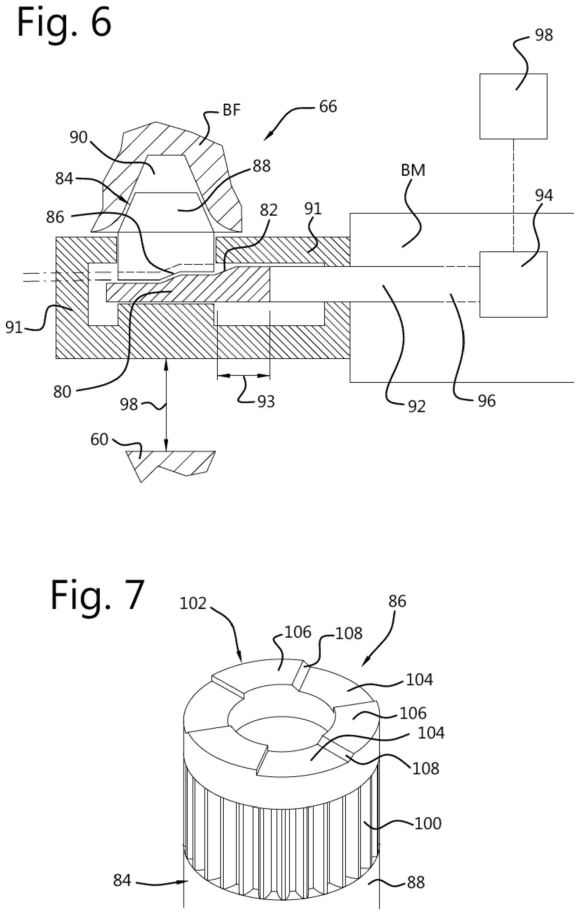

Generally referring to Figure 6, a motor system 66 of the present disclosure may comprise a hydraulically or pneumatically driven wedge element 80. The wedge element may be provided with one, two or more wedge shaped level changes 82 in one of its surfaces 82. A lower surface of a cone element 84 may be provided with a wedge surface 86 corresponding with, and engaging, the stepped surface 82 of the wedge element 80. An opposite end 88 of the cone element may be cone shaped. The opposite end 88 may be arranged in a correspondingly shaped cavity 90 arranged in the base frame BF. The wedge element 80 can be arranged in a suitable container or enclosure 91 which can be connected to, for instance, the balance mass BM or to the base frame BF.

The balance mass BM may be provided with an actuator 92 for driving the wedge element 80. Herein, the wedge element can slide within the enclosure 91, in the direction of first arrow 93. The actuator may be pneumatic or hydraulic. The actuator 92 may, for instance, comprise a pump 94 and a fluid line 96. A controller 98 may be connected to the pump 94 for control thereof.

Please note that the cavity 90 may also be arranged in the balance mass MB, and the wedge element 80 may be connected to the base frame instead. In other words, the operation of the wedge element 80 as described below can be controlled either from the balance mass BM, or from the base frame BF.

By changing the fluid pressure in the fluid line 96, the pump can adjust the position of the wedge element. For instance, the levelled surface 82 of the wedge element 80 may have two levels. The pump 94 can push fluid into the line 96, thereby pushing the wedge 80 under the cone 84, thereby raising the position of the cone. Herein, the cone will push into the cavity 90, and engage the walls thereof. As the base frame BF is substantially stationary and fixated to the environment, the extension of the cone 88 into the cavity will consequently push the balance mass BM away from the base frame, into a first or lowered position. Movement of the enclosure 91 and the connected balance mass is indicated by second arrow 98.

The wedge element may subsequently be retracted. For instance, reducing the pressure in the fluid line 92 will cause the wedge element to shift and retract. As a result, the cone element will retract, causing the balance mass BM to move upward into a second position, or default position. See the second arrow 98.

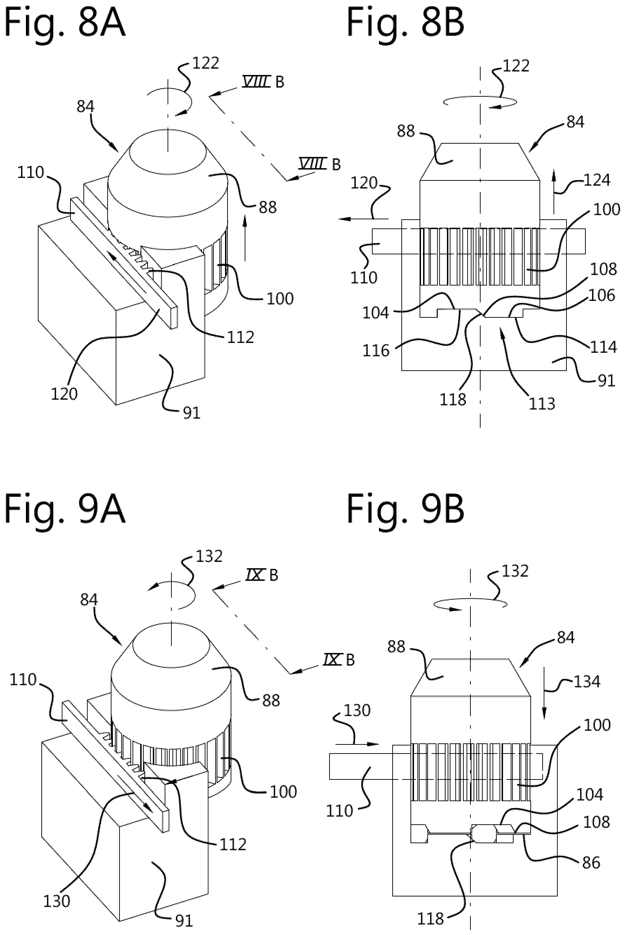

Generally referring to Figure 7, the cone element 86 may be provided with a gear transmission. Herein, for instance, the cone element 84 may be provided with a gear or teethed section 100. The stepped surface 86 may be provided with one, two or more stepped sections 102. Each stepped section 102 may comprise a first level 104 and at least a section level 106 which is elevated with respect to the first level 104. Elevated herein may indicate that the respective level extends further than the first level. An interface section 108 between respective levels 104, 106 may be wedge shaped or angled. The enclosure 91 may be provided with a drive element 110 (see Fig. 8A) provided with toothing or gearing 112 corresponding to the geared section 100 of the cone element. The enclosure 91 may be provided with a stepped surface 113. The stepped surface 113 may be provided with sections comprising two or more levels 114, 116 connected via an angled or wedge shaped section 118. See Figure 8B.

Movement of the drive element 100 (see third arrow 120) may cause the cone element 84 to rotate, via engagement of the teeth of the gearing 112 and the geared section 100. See fourth arrow 122. Upon rotation of the cone element 84, the steps 104, 106 in the stepped sections of the stepped cone surface 86 will move from a first level 114 up to a at least a second level 116 exceeding the first level. Herein, the cone element 84 will extend from the enclosure (see fifth arrow 124) and push into the cavity 90, similar to the embodiment as described with respect to Figure 6. See Figures 9A and 9B, showing the extended position of the cone element 84.

Generally referring to Figures 9A and 9B, movement of the drive element 110 in opposite direction (see arrow 130) will cause the cone element to rotate in opposite direction as well (see arrow 132), causing the cone element to retract (see arrow 134).

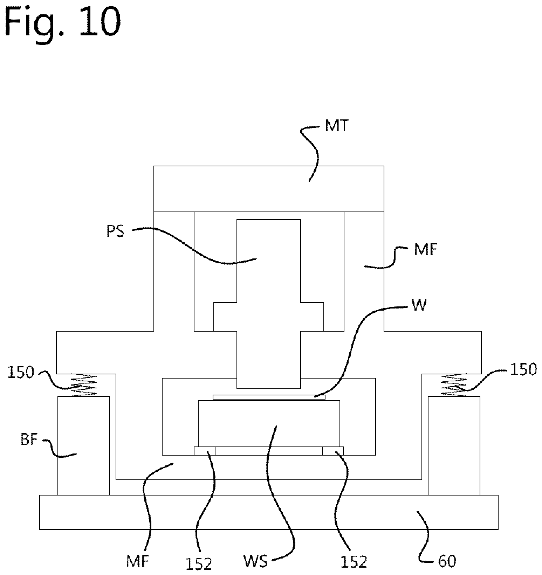

Generally referring to Figure 10, in yet another embodiment, the metrology frame MF may extend and enclosed the substrate stage WS. Herein, the metrology frame can be isolated from the base frame BF via one or more isolating connectors 150. The isolating connectors may comprise any suitable technology available, such as but not limited to springs, dampers, air mounts, bellows, etc. Basically, the connectors 150 isolate the metrology frame MF from vibrations originating in the base frame BF, and vice versa. The projection system PS can be connected to the metrology frame MF.

Height adjustment means 152 may be provided to adjust the vertical position of the substrate stage WS. Herein, the height adjustment means 152 can be arranged between the metrology frame and a lower end of the substrate stage. The height adjustment means 152 may include one of more of adjustable or inflatable bellows, adjustable air mounts, a motor system, a linear actuator, etc.

The height adjustment means basically increase the range of thickness of substrates W which can be processed of handled, by adjusting the position of the wafer stage with respect to a plane of interest, such as the plane of focus of the projection system PS.

The improvement and embodiments as described above provide motorized wafer stage module adjustment in vertical direction (z-direction) with respect to the base frame BF and the metrology frame MF. The extra actuation freedom provided by the system of the present disclosure enables the substrate stage WS to extend the range of substrate thickness which can be handled and reliably processed. Thus, the substrate stage system of the present disclosure is able to cope with both thinner and thicker wafers without losing throughput. In addition, the system of the disclosure obviates expensive redesign of capital intensive components. The substrate stage system of the disclosure can be integrated in legacy lithographic apparatuses, or may be included in new machines.

The substrate stage system of the disclosure enables wafer stage adjustment adjusted with all control systems online. The substrate stage of the disclosure can use available tolerances to significantly increase the available z-budget.

**In** a practical embodiment, the substrate stage of the disclosure is able to handle and process substrates having a thickness ranging from very thin up to for instance 2 mm. For instance, wafer thickness range may be from about 1 µm up to 1500 µm or more.

The embodiments as described herein above may be equally applicable to a wide range of lithography apparatuses. For instance, the embodiments can be applied to DUV systems and EUV systems, allowing to process a wider range of (thicker) substrates.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. For instance, features of various embodiments as described above may be combined.

## Claims

1. A stage system for supporting a substrate having a thickness exceeding a nominal range, comprising:
a base surface;
a first module movably arranged on the base surface;
a second module for supporting the substrate and movably arranged on the first module;
a plane of interest extending on or above a top surface of the second module;
height adjustment means for adjusting vertical positions of the first module and the second module; and
a controller configured to control relative distances between the base surface, the first module, the second module, and the plane of interest, while keeping a summation of the relative distances constant.

2. The stage system of claim 1, wherein the height adjustment means are adapted to also adjust a vertical position of the base surface.

3. The stage system of claim 2, wherein the height adjustment means comprise at least one motor system for adjusting the vertical position of the base surface.

4. The stage system of claim 3, wherein the at least one motor system is arranged between a base frame and a balance mass which includes the base surface.

5. The stage system of claim 3 or 4, wherein the at least one motor system comprises a hydraulic or pneumatic actuator for adjusting a protrusion between a first position and a second, extended position.

6. The stage system of claim 3, 4 or 5, wherein the at least one motor system comprises a mechanic drive system for adjusting a protrusion between a first position and a second, extended position.

7. The stage system of one of the previous claims, wherein the height adjustment means are adapted to adjust the vertical position of the plane of interest.

8. The stage system of claim 7, wherein the height adjustment means include adjustable air mounts coupled to a metrology frame which defines the plane of interest.

9. An exposure apparatus, the apparatus comprising:
stage system for supporting a substrate having a thickness within a nominal range, the stage system comprising:
a base surface;
a first module movably arranged on the base surface;
a second module for supporting the substrate and movably arranged on the first module;
a plane of interest extending on or above a top surface of the second module;
height adjustment means for adjusting vertical positions of the first module and the second module; and
a controller configured to control relative distances between the base surface, the first module, the second module, and the plane of interest, while keeping a summation of the relative distances constant.

10. The exposure apparatus of claim 9, the stage system comprising:
at least one substrate handler for moving substrates onto the second module;
an exposure system for exposing a substrate positioned on the second module;
wherein the controller is adapted to reduce a vertical position of a respective substrate with respect to the exposure system if a thickness of the substrate exceeds the nominal range.

11. The exposure apparatus of claim 9 or 10, comprising a metrology frame which is connected to the exposure system, and
second height adjustment means for adjusting a vertical position of the metrology frame with respect to the second module.

12. The exposure system of claim 11, the second height adjustment means comprising adjustable air mounts supporting the metrology frame.

13. A method for supporting a substrate having a thickness exceeding a nominal range, comprising:
providing a stage system, the stage system comprising
a base surface;
a first module movably arranged on the base surface;
a second module for supporting the substrate and movably arranged on the first module; and
a plane of interest extending on or above a top surface of the second module;
arranging a substrate on the second module; and
if a thickness of the substrate exceeds the nominal range, adjusting relative distances between the base surface, the first module, the second module, and the plane of interest, while keeping a summation of the relative distances constant.

14. The method of claim 13, wherein the step of adjusting relative distances comprises controlling a first vertical distance of the second module with respect to the first module, and controlling a second vertical distance of the first module with respect to the base surface.

15. The method of claim 13 or 14, the method comprising the further step of adjusting a vertical position of the base surface; or adjusting a vertical position of the plane of interest.
